# EUROPEAN PATENT SPECIFICATION

(11) **EP 2 704 343 B1**
(45) Date of publication and mention of the grant of the patent: **04.11.2015**
(21) Application number: 12182896.6
(22) Date of filing: 04.09.2012
(51) Int. Cl.: H04J 14/02, H01S 5/026

(54) **Multi-wavelength fast tunable transmission device and optical packet switching node**
Schnelle wellenlängenabstimmbare Laser
Lasers à longueur d'onde accordable rapide

(43) Date of publication of application: 05.03.2014
(73) Proprietor: ALCATEL LUCENT, 92100 Boulogne-Billancourt (FR)
(72) Inventor: Vacondio, Francesco, 91620 NOZAY (FR); Charlet, Gabriel, 91620 NOZAY (FR)
(74) Representative: Sciaux, Edmond

(56) References cited:
- KOTAKI Y ET AL: "Wavelength tunable DFB laser array for WDM applications", ECOC 2002. 28TH EUROPEAN CONFERENCE ON OPTICAL COMMUNICATION (IEEE CAT. NO. 02TH8640) IEEE PISCATAWAY, NJ, USA, [Online] vol. 2, 2002, XP002688049, ISBN: 87-90974-64-6 IEEEXPLORE Retrieved from the Internet: URL:http://ieeexplore.ieee.org/stamp/stamp .jsp?tp=&arnumber=1600970> [retrieved on 2012-11-26]
- PEZESHKI B ET AL: "12 element multi-wavelength DFB arrays for widely tunable laser modules", OPTICAL FIBER COMMUNICATIONS CONFERENCE. (OFC). POSTCONFERENCE TECHNICAL DIGEST. POSTDEADLINE PAPERS (IEEE CAT. NO.02CH37339) OPT SOC. AMERICA WASHINGTON, DC, USA; [TRENDS IN OPTICS AND PHOTONICS SERIES. (TOPS)], IEEE, vol. TOPS. VOL. 70, 17 March 2002 (2002-03-17), pages 711-712, XP010618084, DOI: 10.1109/OFC.2002.1036667 ISBN: 978-1-55752-701-1

## Description

### Field of the invention

The invention relates to the technical field of wavelength-tunable optical sources, and in particular fast tunable laser sources suitable for optical communication systems employing a packet granularity.

### Background

Optical packet switching networks employing Wavelength Division Multiplexing (WDM) provide flexibility, high capacity and efficient use of the bandwidth through multiplexing techniques in both time and wavelength. Optical packet switching, especially when paired with coherent reception, is a promising technology to realize very efficient networks, e.g. high capacity switch/routers, and to provide an efficient aggregation mechanism in a ring network. An optical packet add and drop multiplexer (OPADM) for a WDM network makes it possible to perform fundamental functions such as optical packet insertion, optical packet extraction and transparent forwarding of transit traffic on each of a plurality of wavelength channels. The optical transparency of the transit path reduces dramatically the number of transponders required to make such equipment.

As a conventional Reconfigurable Optical Add Drop Multiplexer, an OPADM typically comprises an optical unit managing the transit traffic in the optical domain, dropping traffic to a drop module and adding traffic from an a²dd module, and an electronic unit that comprises the add and drop modules and interfaces with client devices. Examples of OPADM architectures are described in "Optical Packet Add/Drop Multiplexers for packet ring networks," Proceedings of ECOC 2008, Brussels Expo, Belgium, pp 103-106, XP001524738, in EP-A1-2160045 and EP-A1-2458761.

Document "Wavelength Tunable DFB Laser Array for WDM Applications", Yuji Kotaki and Ken Morito, Fujitsu Laboratories Ltd., discloses a wavelength tunable optical transmission device according to the preamble of claim 1.

### Summary

In an embodiment, the invention provides a wavelength-tunable optical transmission device comprising:
a multi-wavelength array chip including a plurality of laser sources, each laser source being tunable over a respective fine range of wavelengths of the laser source,
wherein the fine ranges of the plurality of laser sources continuously span a total range of wavelengths of the laser optical transmission device, characterized by:
   a first optical combiner arranged to guide the optical signals generated by a first subset of the laser sources to a first optical gate,
   a second optical combiner arranged to guide the optical signals generated by a second subset of the laser sources to a second optical gate, and
   a transmission controller adapted to perform repeatedly a first tuning and sending sequence and a second tuning and sending sequence in a time-offset manner to send optical packets with the first subset of the laser sources and with the second subset of the laser sources at different instants in time on different wavelength channels located within the total range,
   wherein the first tuning and sending sequence comprises closing the first optical gate, selecting a laser source in the first subset as a function of a first target wavelength channel so that the fine range of the laser source includes the first target wavelength channel, tuning the selected laser source to the first target wavelength channel and opening the first optical gate, and
   wherein the second tuning and sending sequence comprises closing the second optical gate, selecting a laser source in the second subset as a function of a second target wavelength channel so that the fine range of the laser source includes the second target wavelength channel, tuning the selected laser source to the second target wavelength channel and opening the second optical gate.

In an embodiment, the optical transmission device further comprises an output combiner arranged to guide the optical signals passed by the first and second optical gates to a shared optical output.

In an embodiment, the optical transmission device further comprises an optical modulator arranged for modulating the optical signals passed by the optical output.

In an embodiment, the optical modulator is adapted to modulate the optical signals in accordance with a multilevel Quadrature Amplitude Modulation scheme.

In an embodiment, the fine range of each laser source spans 2.7 nm or more.

In an embodiment, the fine tuning of a laser source is performed by controlling a temperature of the laser source.

In an embodiment, the laser sources are in the number of 12 or more.

In an embodiment, the laser sources in a subset are in the number of 6 or more.

In an embodiment, the total range of wavelengths spans 32 nm or more in the C band.

In an embodiment, the laser sources are distributed feedback (DFB) laser sources.

In an embodiment, the invention also provides an optical packet switching node comprising:
an input section for receiving optical packets,
a controller adapted to receive control data associated to the optical packets,
an output section for transmitting optical packets,
an optical transit section adapted to pass optical packets from the input section to the output section, and
an optical packet drop section including an optical packet receiver connected to the input section and adapted to demodulate an optical packet,
and an optical packet add section including an optical transmission device adapted to transmit an optical packet to the output section

Aspects of the invention stem from the observation that fast tunable lasers are required to fully benefit from the advantages of optical packet switching in WDM networks.

Aspects of the invention stem from the observation that tunable lasers cannot be switched as fast as a few nanoseconds, which would be necessary to tune the wavelength during the time between two packets, and cannot be maintained stable with a narrow linewidth for the packet duration, which would be necessary for optimal operation of a coherent receiver.

Aspects of the invention are based on the idea of providing a transmitter device capable of tuning the output wavelength in as short a time as tens or hundreds of nanoseconds.

### Brief description of the drawings

These and other aspects of the invention will be apparent from and elucidated with reference to the embodiments described hereinafter, by way of example, with reference to the drawings.
Figure 1 is a functional representation of a tunable optical packet transmitter.
Figure 2 is a flow diagram showing an operation of the transmitter of Fig. 1 in time.
Figure 3 is a graph showing the range of wavelengths attainable by each of the DFB laser sources of the transmitter of Fig. 1.

### Detailed description of the embodiments

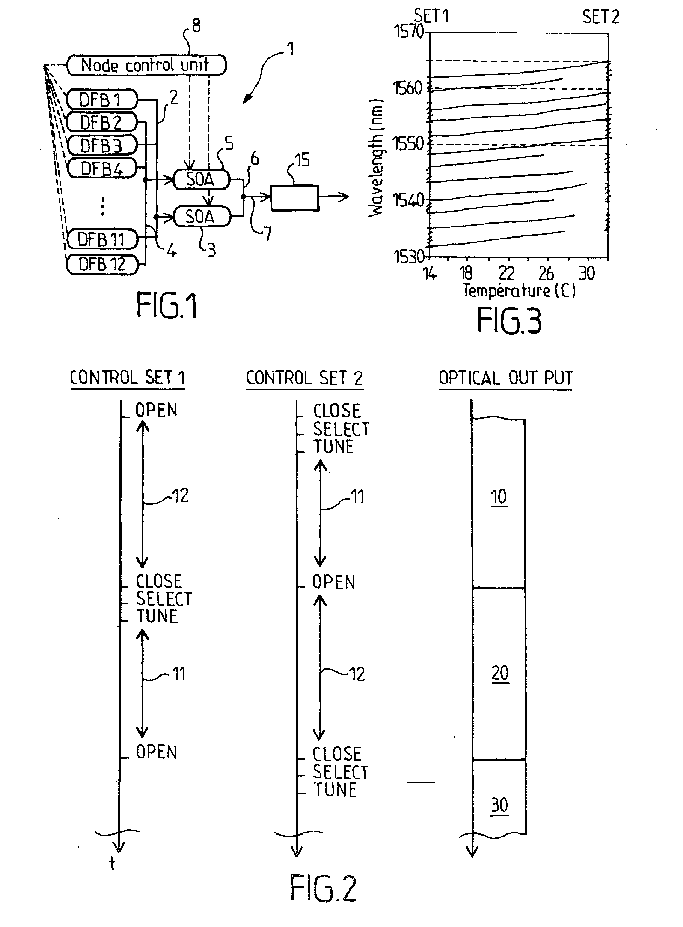

With reference to Figure 1, a tunable optical packet transmitter 1 comprises a plurality of DFB laser sources. The embodiment shown comprises 12 laser sources designated as DFB1 to DFB12. A higher or lower number of DFB laser sources can be made in the same manner.

The DFB laser sources can be made in an integrated manner as a multi-wavelength array chip. Further details about the making of such an array chip are disclosed in B. Pezeshki et al., "12 element multi-wavelength DFB arrays for widely tunable laser modules", paper ThGG71, OFC 2002, pp 711-712. Such an array chip offers the advantages of a simple, compact, low-cost and high-yield chip design with proven technological maturity. The disclosed 12 elements multi-wavelength array can be tuned over 32nm in the C band. Each element of the multi-wavelength array can be individually tuned over 2.7nm through temperature control.

As shown on Fig. 1, the laser sources DFB1 to DFB12 are split in two subsets or more through the use of optical combiners. More precisely, the optical combiner 2 couples the outputs of a first half of the laser sources to a semiconductor optical amplifier (SOA) 3 that operates as an optical gate. Similarly, the optical combiner 4 couples the outputs of a second half of the laser sources to a semiconductor optical amplifier (SOA) 5 that operates as a second optical gate. In the embodiment shown, the first subset comprises all laser sources with an odd rank and the second subset comprises all laser sources with an even rank. However, the grouping could be done otherwise.

The outputs of the two SOAs 3 and 5 are connected to a single optical output 7 by an optical combiner 6. The optical combiners 2 4 and 6 refer to non-colored components, i.e. capable of passing all wavelengths within the operating range of the transmitter.

The wavelength tunability of the transmitter 1 is illustrated in Fig. 3. Namely, each DFB source has a unique fine-tuning range shown by a continuous line in Fig. 3. The lowest line corresponds to DFB1 and the top line to DFB12. Together, the fine tuning ranges of the DFB sources span the entire interval 1532 to 1565 nm, with some overlap. The left-hand side vertical axis on Fig. 3 shows the spectral intervals that can be attained by the DFB sources in the first subset and the righthand side vertical axis on Fig. 3 shows the spectral intervals that can be attained by the DFB sources in the second subset.

With reference to Figure 2, the operation of the fast tunable transmitter will now be described. Figure 2 depicts a process that is performed repeatedly in time under the control of a control unit 8. In this process, the optical gates 3 and 5 are alternatively opened and closed in opposition so that only one of the two subsets can send an optical signal at every instant in time. While an optical gate remains open, a laser source that has been previously tuned to the desired wavelength sends an optical signal, which reaches the transmitter output 7. During that period depicted by arrow 12, a laser source in the other subset is being tuned to the desired wavelength channel for the next packet to be emitted. Therefore, the time period taken by the tuning process, which is depicted by arrow 11, overlaps entirely or almost entirely the transmitting period 12 of the other source. In this manner, it is possible to set the inter-packet interval, i.e. the time gap between two consecutive packets sent by the transmitter 1 independently form the duration of the tuning process. Furthermore, as shown, the inter-packet interval can be reduced to almost zero to optimize capacity.

The control unit 8 performs an identical sequence of operations with each of the two subsets of optical sources, namely:
- Closing the optical gate at the end of the optical packet being sent,
- obtaining the next wavelength to be transmitted, which could be communicated e.g. as a standard ITU channel number by a node controller,
- selecting a laser source within the subset of which the tuning range contains the next wavelength,
- activating and tuning the laser source by temperature control, and
- opening the optical gate when the optical packet must be sent.

Figure 2 also shows the optical signals obtained at the output 7, namely a first optical packet 10 sent by a source of the first subset, then a second optical packet 20 sent by a source of the second subset, then a third optical packet 30 sent by a source of the first subset, and so on.

This process may take place in a synchronous network, e.g. as disclosed in EP-A1-2458761. In particular, the transmitter 1 can be installed in the add module of a packet switching node. A constraint results from the fact that a subset of the sources may not be able to tune to all wavelengths channels, as shown on Fig. 3. Therefore, a subset may sometimes not be capable of sending useful traffic at its turn, due to a mismatch between the desired wavelength and the tuning range of the subset. Overall, such instances do not substantially degrade the network efficiency thanks to the possibility for other nodes in the packet network to reuse the time slot left available. Furthermore, wavelength assignment can be optimized to reduce the probability of such mismatches.

Fig. 1 also shows an external optical modulator 15 arranged at the output 7 to modulate the sent optical packets. In an embodiment, a modulation scheme with a large constellation such as QAM16 or QAM64 is used. For such constellations, the narrow linewidth of the laser sources is critical.

In the above-described embodiment, the laser sources are distributed feedback (DFB) laser sources. Other sorts of laser sources can be arranged and used in the same manner, e.g. any flavor of distributed Bragg grating (DBR) sources.

Elements such as the control units could be e.g. hardware means like e.g. an ASIC, or a combination of hardware and software means, e.g. an ASIC and an FPGA, or at least one microprocessor and at least one memory with software modules located therein.

The appended claims are to be construed as embodying all modification and alternative constructions that may be occurred to one skilled in the art, which fairly fall within the basic teaching here, set forth.

Furthermore, the use of the article "a" or "an" preceding an element or step does not exclude the presence of a plurality of such elements or steps.

In the claims, any reference signs placed between parentheses shall not be construed as limiting the scope of the claims.

## Claims

1. A wavelength-tunable optical transmission device (1) comprising:
a multi-wavelength array chip including a plurality of (DFB1, ... DFB 12) laser sources, each laser source being tunable over a respective fine range of wavelengths of the laser source, wherein the fine ranges of the plurality of laser sources continuously span a total range of wavelengths of the laser optical transmission device, a first optical combiner (2) arranged to guide the optical signals generated by a first subset of the laser sources to a first optical gate (3),
the wavelength-tunable optical transmission device being **characterized by**:
a second optical combiner (4) arranged to guide the optical signals generated by a second subset of the laser sources to a second optical gate (5), and
a transmission controller (8) adapted to perform repeatedly a first tuning and sending sequence and a second tuning and sending sequence in a time-offset manner to send optical packets (10, 20, 30) with the first subset of the laser sources and with the second subset of the laser sources at different instants in time on different wavelength channels located within the total range, wherein the first tuning and sending sequence performed by the transmission controller (8) comprises closing the first optical gate (3), selecting a laser source in the first subset as a function of a first target wavelength channel so that the fine range of the laser source includes the first target wavelength channel, tuning (11) the selected laser source to the first target wavelength channel and opening the first optical gate (3), and
wherein the second tuning and sending sequence performed by the transmission controller (8) comprises closing the second optical gate (5), selecting a laser source in the second subset as a function of a second target wavelength channel so that the fine range of the laser source includes the second target wavelength channel, tuning (11) the selected laser source to the second target wavelength channel and opening the second optical gate (5), wherein the time period taken by the tuning of the selected laser source of the second subset overlaps the time period during which the selected laser source of the first subset is transmitting an optical packet.

2. The optical transmission device in accordance with claim 1, further comprising an output combiner (6) arranged to guide the optical signals passed by the first and second optical gates to a shared optical output (7).

3. The optical transmission device in accordance with claim 2, further comprising an optical modulator (15) arranged for modulating the optical signals passed by the optical output (7).

4. The optical transmission device in accordance with claim 3, wherein the optical modulator (15) is adapted to modulate the optical signals in accordance with a multilevel Quadrature Amplitude Modulation scheme.

5. The optical transmission device in accordance with any one of claims 1 to 4, wherein the fine range of each laser source spans 2.7 nm or more.

6. The optical transmission device in accordance with any one of claims 1 to 5, wherein the fine tuning of a laser source is performed by controlling a temperature of the laser source.

7. The optical transmission device in accordance any one of claims 1 to 6, wherein the laser sources are in the number of 12 or more.

8. The optical transmission device in accordance any one of claims 1 to 7, wherein the laser sources in a subset are in the number of 6 or more.

9. The optical transmission device in accordance any one of claims 1 to 8, wherein the total range of wavelengths spans 32 nm or more in the C band.

10. The optical transmission device in accordance any one of claims 1 to 9, wherein the laser sources are distributed feedback laser sources.

11. An optical packet switching node comprising:
an input section for receiving optical packets,
a controller adapted to receive control data associated to the optical packets,
an output section for transmitting optical packets,
an optical transit section adapted to pass optical packets from the input section to the output section, and
an optical packet drop section including an optical packet receiver connected to the input section and adapted to demodulate an optical packet,
and an optical packet add section including an optical transmission device (1) adapted to transmit an optical packet to the output section, **characterized in that** the optical transmission device is accordance with any one of claims 1 to 10.

## Patentansprüche

1. Optische Übertragungsvorrichtung (1) mit abstimmbarer Wellenlänge, umfassend:
einen Multi-Wellenlängen-Array-Chip, der eine Mehrzahl von (DFB1,... DFB12) Laserquellen aufweist, wobei jede Laserquelle über einen jeweiligen Feinbereich von Wellenlängen der Laserquelle abstimmbar ist, wobei die Feinbereiche der Mehrzahl von Laserquellen durchgehend einen Gesamtwellenlängenbereich der optischen Laserübertragungsvorrichtung überspannen, wobei ein erster optischer Kombinator (2) eingerichtet ist, um die optischen Signale, die von einem ersten Subsatz der Laserquellen erzeugt werden, zu einem ersten optischen Gate (3) zu führen,
optische Übertragungsvorrichtung mit einstellbarer Wellenlänge **dadurch gekennzeichnet, dass**:
ein zweiter optischer Kombinator (4) eingerichtet ist, um die optischen Signale, die von einem zweiten Subsatz der Laserquellen erzeugt werden, zu einem zweiten optischen Gate (5) zu führen, und
ein Übertragungscontroller (8) angepasst ist, um wiederholt eine erste Abstimm- und Sendesequenz und eine zweite Abstimm- und Sendesequenz in einer zeitlich versetzten Art auszuführen, um optische Pakete (10, 20, 30) mit dem ersten Subsatz der Laserquellen und mit dem zweiten Subsatz der Laserquellen in unterschiedlichen zeitlichen Augenblicken auf Kanälen mit unterschiedlichen Wellenlängen, die innerhalb des Gesamtbereichs liegen, zu senden, wobei die erste Abstimm- und Sendesequenz, die von dem Übertragungscontroller (8) ausgeführt wird, das Schließen des ersten optischen Gates (3), das Auswählen einer Laserquelle aus dem ersten Subsatz in Abhängigkeit von einem Kanal mit einer ersten Zielwellenlänge derart umfasst, dass der Feinbereich der Laserquelle den Kanal mit der ersten Zielwellenlänge aufweist, Abstimmen (11) der ausgewählten Laserquelle auf den Kanal mit der ersten Zielwellenlänge und Öffnen des ersten optischen Geräts (3), und
wobei die zweite Abstimm- und Sendesequenz, die von dem Übertragungscontroller (8) ausgeführt wird, das Schließen des zweiten optischen Gates (5), das Auswählen einer Laserquelle aus dem zweiten Subsatz in Abhängigkeit von einem Kanal mit einer zweiten Zielwellenlänge derart umfasst, dass der Feinbereich der Laserquelle den Kanal mit der zweiten Zielwellenlänge aufweist, Abstimmen (11) der ausgewählten Laserquelle auf den Kanal mit der zweiten Zielwellenlänge und Öffnen des zweiten optischen Gates (5), wobei die Zeitspanne, die von dem Abstimmen der ausgewählten Laserquelle des zweiten Subsatzes die Zeitspanne, während der die ausgewählte Laserquelle des ersten Subsatzes ein optisches Paket überträgt, überlagert.

2. Optische Übertragungsvorrichtung nach Anspruch 1, die ferner einen Ausgangskombinator (6) umfasst, der eingerichtet ist, um die optischen Signale, die durch das erste und das zweite optische Gerät durchgegeben werden, zu einem gemeinsamen optischen Ausgang (7) zu führen.

3. Optische Übertragungsvorrichtung nach Anspruch 2, die ferner einen optischen Modulator (15) umfasst, der eingerichtet ist, um die optischen Signale, die durch den optischen Ausgang (7) durchgegeben werden, zu modulieren.

4. Optische Übertragungsvorrichtung nach Anspruch 3, wobei der optische Modulator (15) angepasst ist, um die optischen Signale in Übereinstimmung mit einem Quadratur-Amplitudenmodulations-System mit mehreren Niveaus zu modulieren.

5. Optische Übertragungsvorrichtung nach einem der Ansprüche 1 bis 4, wobei der Feinbereich jeder Laserquelle 2,7 nm oder mehr überspannt.

6. Optische Übertragungsvorrichtung nach einem der Ansprüche 1 bis 5, wobei die Feinabstimmung einer Laserquelle durch Steuern einer Temperatur der Laserquelle ausgeführt wird.

7. Optische Übertragungsvorrichtung nach einem der Ansprüche 1 bis 6, wobei 12 Laserquellen oder mehr vorhanden sind.

8. Optische Übertragungsvorrichtung nach einem der Ansprüche 1 bis 7, wobei in einem Subsatz 6 oder mehr Laserquellen sind.

9. Optische Übertragungsvorrichtung nach einem der Ansprüche 1 bis 8, wobei der Gesamtbereich der Wellenlängen 32 nm oder mehr in dem C-Band überspannt.

10. Optische Übertragungsvorrichtung nach einem der Ansprüche 1 bis 9, wobei die Laserquellen Distributed Feedback (DFB)-Laserquellen sind.

11. Optischer Paketvermittlungsknoten umfassend:
einen Eingangsabschnitt zum Empfangen optischer Pakete,
einen Controller, der angepasst ist, um Steuerdaten in Zusammenhang mit den optischen Paketen zu empfangen,
einen Ausgangsabschnitt zum Übertragen optischer Pakete,
einen optischen Transitabschnitt, der angepasst ist, um optische Pakete von dem Eingangsabschnitt zu dem Ausgangsabschnitt weiterzugeben, und
einen Drop-Abschnitt für optisches Paket, der einen Empfänger für optisches Paket aufweist, der mit dem Eingangsabschnitt verbunden und angepasst ist, um ein optisches Paket zu demodulieren, und
einen Add-Abschnitt für optisches Paket, der eine optische Übertragungsvorrichtung (1) aufweist, die angepasst ist, um ein optisches Paket zu dem Ausgangsabschnitt zu übertragen, **dadurch gekennzeichnet, dass** die optische Übertragungsvorrichtung einem der Ansprüche 1 bis 10 entspricht.

## Revendications

1. Dispositif de transmission optique à longueur d'onde accordable (1) comprenant :
une puce à réseau à longueurs d'onde multiples incluant une pluralité de (DFB1, ... DFB12) sources laser, chaque source laser étant accordable sur une gamme fine respective de longueurs d'onde de la source laser, dans lequel les gammes fines de la pluralité de sources laser couvrent en continu une gamme totale de longueurs d'onde du dispositif de transmission optique laser, un premier combineur optique (2) étant agencé pour guider les signaux optiques générés par un premier sous-jeu des sources laser vers une première porte optique (3),
le dispositif de transmission optique à longueur d'onde accordable étant **caractérisé par** :
un second combineur optique (4) agencé pour guider les signaux optiques générés par un second sous-jeu des sources laser vers une seconde porte optique (5), et
un contrôleur de transmission (8) adapté pour exécuter, à répétition et avec un décalage temporel, une première séquence d'accord et d'envoi et une seconde séquence d'accord et d'envoi, afin d'envoyer des paquets optiques (10, 20, 30) avec le premier sous-jeu des sources laser et avec le second sous-jeu des sources laser à des instants différents dans le temps sur des canaux de longueurs d'onde différentes se trouvant dans la gamme totale, dans lequel la première séquence d'accord et d'envoi exécutée par le contrôleur de transmission (8) comprend la fermeture de la première porte optique (3), la sélection d'une source laser dans le premier sous-jeu en fonction d'un premier canal de longueur d'onde cible, de telle sorte que la gamme fine de la source laser inclut le premier canal de longueur d'onde cible, l'accord (11) de la source laser sélectionnée sur le premier canal de longueur d'onde cible, et l'ouverture de la première porte optique (3), et
dans lequel la seconde séquence d'accord et d'envoi exécutée par le contrôleur de transmission (8) comprend la fermeture de la seconde porte optique (5), la sélection d'une source laser dans le second sous-jeu en fonction d'un second canal de longueur d'onde cible, de telle sorte que la gamme fine de la source laser inclut le second canal de longueur d'onde cible, l'accord (11) de la source laser sélectionnée sur le second canal de longueur d'onde cible, et l'ouverture de la seconde porte optique (5), dans lequel la période de temps prise par l'accord de la source laser sélectionnée du second sous-jeu est superposée à la période de temps durant laquelle la source laser sélectionnée du premier sous-jeu transmet un paquet optique.

2. Dispositif de transmission optique selon la revendication 1, comprenant en outre un combineur de sortie (6) agencé pour guider les signaux optiques passant par les première et seconde portes optiques vers une sortie optique partagée (7).

3. Dispositif de transmission optique selon la revendication 2, comprenant en outre un modulateur optique (15) agencé pour moduler les signaux optiques passant par la sortie optique (7).

4. Dispositif de transmission optique selon la revendication 3, dans lequel le modulateur optique (15) est adapté pour moduler les signaux optiques conformément au principe de la modulation d'amplitude en quadrature.

5. Dispositif de transmission optique selon l'une quelconque des revendications 1 à 4, dans lequel la gamme fine de chaque source laser couvre 2,7 nm ou davantage.

6. Dispositif de transmission optique selon l'une quelconque des revendications 1 à 5, dans lequel l'accord fin d'une source laser est exécuté en contrôlant une température de la source laser.

7. Dispositif de transmission optique selon l'une quelconque des revendications 1 à 6, dans lequel les sources laser sont au nombre de 12 ou davantage.

8. Dispositif de transmission optique selon l'une quelconque des revendications 1 à 7, dans lequel les sources laser dans le sous-jeu sont au nombre de 6 ou davantage.

9. Dispositif de transmission optique selon l'une quelconque des revendications 1 à 8, dans lequel la gamme totale de longueurs d'onde couvre 32 nm ou davantage de la bande C.

10. Dispositif de transmission optique selon l'une quelconque des revendications 1 à 9, dans lequel les sources laser sont des sources laser à rétroaction distribuée.

11. Noeud de commutation optique par paquets comprenant :
une section d'entrée pour la réception de paquets optiques,
un contrôleur adapté pour recevoir des données de contrôle associées aux paquets optiques,
une section de sortie pour transmettre des paquets optiques,
une section de transit optique adaptée pour faire passer des paquets optiques de la section d'entrée à la section de sortie,
une section d'extraction de paquet optique incluant un récepteur de paquet optique connecté à la section d'entrée et adapté pour démoduler un paquet optique, et
une section d'insertion de paquet optique incluant un dispositif de transmission optique (1) adapté pour transmettre un paquet optique à la section de sortie, **caractérisé en ce que** le dispositif de transmission optique se présente selon l'une quelconque des revendications 1 à 10.
